# FASCICULE DE BREVET EUROPEEN

(11) **EP 1 550 361 B1**
(45) Date de publication et mention de la délivrance du brevet: **25.01.2012**
(21) Numéro de dépôt: 03807893.7
(22) Date de dépôt: 10.10.2003
(51) Int. Cl.: H01L 25/18, H05K 7/14, H05K 1/14

(54) **MODULE ELECTRONIQUE A TROIS DIMENSIONS**
DREIDIMENSIONALES ELEKTRONISCHES MODUL
THREE-DIMENSIONAL ELECTRONIC MODULE

(30) Priorité: 11.10.2002 FR 0212681
(43) Date de publication de la demande: 06.07.2005
(73) Titulaire: Thales, 92526 Neuilly Sur Seine (FR)
(72) Inventeur: SARNO, Claude Thales Intellectual Property, F-94117 Arcueil Cedex (FR); DURAND, Jean-Luc Thales Intellectual Property, F-94117 Arcueil Cedex (FR); JARNIAS, Christophe Thales Intellectual Property, F-94117 Arcueil Cedex (FR)
(74) Mandataire: Brunelli, Gérald
(86) Numéro de dépôt international: PCT/FR2003/002999
(87) Numéro de publication internationale: WO 2004/034761

(56) Documents cités:
- EP-A- 0 461 753
- EP-A- 0 545 563
- EP-A- 0 560 502
- US-A- 3 648 113
- US-A- 3 904 933
- US-A- 5 677 830

## Description

L'invention concerne un module électronique à trois dimensions (3D), c'est-à-dire comportant un empilement de plusieurs substrats électroniques dans un volume réduit. Un substrat électronique comporte de manière classique, un support et des composants.

Un module électronique 3D est typiquement constitué de plusieurs strates de substrats électroniques moulées dans de la résine. L'interconnexion électrique entre les strates de substrats électroniques est assurée par des conducteurs gravés sur les parois externes du module 3D. Ce module 3D a typiquement les dimensions suivantes de l'ordre de : 5 X 5 X 5 cm³.

Le domaine de l'invention est celui de la dissipation thermique dans les modules électroniques 3D. Ces modules 3D sont utilisés dans des secteurs aussi variés que l'aéronautique, les télécommunications, les transports (automobiles, ferroviaires, ...) et peuvent concerner des alimentations, des capteurs, des dispositifs GPS, etc.

Du document US3904933, on connaît un dispositif comprenant un empilement de substrats électroniques comprenant chacun un cadre comprenant un premier coté et un second coté incluant une pluralité de connecteurs adaptés pour être connectés aux connecteurs femelles correspondants inclus dans une plaque périphérique disposée sur la face du dispositif.

Du document EP0545563, on connaît un empilement de substrats électroniques, chacun de ces substrats étant disposé sur un renfoncement d'un dispositif à refroidissement de phase. Des connecteurs du commerce sont interposés entre les contacts électriques individuels des substrats.

Du document US648113, on connaît un appareil électronique comprenant des unités électroniques empilées. Chaque unité comprend deux plaques stratifiées supportées par un cadre creux constitué d'une matière conductrice de chaleur. Une plaque stratifiée comprend une plaque à circuit imprimé, une feuille mince à conduction thermique et un isolant pour déposer la plaque sur la feuille mince. Le cadre comprend des ouvertures destinées à la circulation d'un fluide de refroidissement. Des connexions électriques sont prévues pour connecter les plaques à circuit imprimé à travers un bord du cadre. Les connexions électriques comportent des contacts électriques mâles-femelles pour relier l'unité électronique à une plaque mère.

Du document EP0560502, on connaît un assemblage électronique comportant des modules empilés. Un module comprend un substrat électronique, un cadre dans un matériau isolant tel que de la résine synthétique et des terminaisons individuelles, en forme de C entourant le cadre, reliées aux pistes du substrat et destinées à connecter le substrat à un substrat voisin.

La densité de puissance des substrats électroniques augmente régulièrement en fonction de l'accroissement du nombre de composants d'un même substrat et de leur miniaturisation ; elle peut atteindre voire dépasser 20 W.

Une première solution au problème de dissipation thermique d'un substrat électronique consiste à utiliser un ventilateur ou une micropompe qui nécessite une alimentation externe, source de chaleur, de poids et d'encombrement supplémentaires ; en outre, la dissipation de la chaleur n'est pas répartie de manière homogène.

Une autre solution consiste à dissiper la chaleur par drainage au moyen d'un ajout de matière thermiquement conductrice comme le cuivre, ce qui compte tenu du poids du cuivre, revient à alourdir le substrat de façon significative.

Une troisième solution consiste à intégrer dans l'épaisseur du support du substrat, un dispositif de refroidissement à changement de phase tel qu'un caloduc constitué d'une boîte métallique contenant de la vapeur d'eau qui se condense sous l'effet d'un refroidissement. Le caloduc a pour inconvénient d'être encombrant et de ne pas avoir une bonne tenue aux contraintes d'environnement telle que l'accélération.

Ces inconvénients présentés dans le cas d'un substrat électronique sont amplifiés lorsqu'il s'agit de dissiper la chaleur dans un module électronique comportant un empilement de substrats électroniques.

Un but important de l'invention est donc d'améliorer la dissipation thermique d'un module électronique 3D.

Par ailleurs, les modules électroniques 3D existants sont configurés de telle façon que l'on ne peut ni accéder à l'un des substrats ni le modifier, le changer ou réutiliser un substrat existant sur étagère.

Un autre but de l'invention est donc de disposer d'un module électronique 3D ne présentant pas ces inconvénients.

Pour atteindre ces buts, l'invention propose un substrat électronique apte à être inclus dans un empilement comportant ledit substrat électronique et au moins un autre substrat électronique et apte à être connecté à l'autre (ou aux autres) substrat(s) électronique(s) et éventuellement à une interface d'entrée-sortie, principalement caractérisé en ce qu'il comprend un cadre constitué d'un matériau à haute conductivité thermique, comprenant plusieurs côtés, dont au moins un premier côté est destiné à être en contact avec le côté correspondant du cadre d'un autre (ou des autres) substrat(s) voisin(s) de manière à assurer la dissipation thermique des substrats électroniques et dont au moins un deuxième côté comprend un élément d'interconnexion destiné à assurer l'interconnexion électrique entre ledit substrat électronique et l'autre (ou les autres) substrat(s) électronique(s) au moyen d'un circuit de routage et/ou entre ledit substrat électronique et l'interface d'entrée-sortie.

Chaque cadre a ainsi pour fonction d'assurer les échanges thermiques et les contacts électriques entre les substrats et/ou entre un substrat (ou plusieurs) et l'interface d'entrée-sortie.

Il suffit ainsi de modifier le circuit de routage pour modifier les interconnexions entre le substrat électronique et les autres substrats sans intervenir sur le substrat : il en résulte une interchangeabilité et une modularité accrues.

Selon une caractéristique préférentielle de l'invention, au moins un cadre comporte un fond constitué d'un matériau à haute conductivité thermique, ce fond comportant éventuellement un élément à refroidissement à changement de phase. Ce mode de refroidissement est de préférence choisi pour dissiper une puissance supérieure à environ 5 W.

Selon un mode de réalisation préférentiel, chaque substrat présente des pistes conductrices et l'élément d'interconnexion comporte un premier élément conducteur destiné à être en contact avec les pistes, un deuxième élément conducteur destiné à être connecté au circuit de routage en vue de connecter ce deuxième élément conducteur à au moins un élément conducteur de l'élément d'interconnexion du cadre d'un substrat voisin.

Selon une caractéristique préférentielle de l'invention, le cadre comporte des moyens réversibles de positionnement destinés à positionner ledit cadre par rapport au cadre de l'autre substrat électronique voisin et/ou par rapport à l'interface d'entrée-sortie

Le positionnement des substrats encadrés, les uns par rapport aux autres n'est alors pas définitif : les substrats encadrés sont amovibles. Ils peuvent aisément être désolidarisés les uns des autres, afin par exemple d'être remplacés ou modifiés.

L'invention a pour objet un module électronique comportant une interface d'entrée-sortie et un empilement de plusieurs substrats-électroniques tels que celui qui vient d'être précédemment décrit.

Il comporte en outre de préférence un boîtier apte à recevoir l'empilement de substrats électroniques encadrés et/ou un capot comprenant l'interface d'entrée-sortie.

Selon une caractéristique préférentielle de l'invention, le capot comporte des moyens de fixation au boîtier, de préférence amovibles et les moyens de fixation sont aptes à stabiliser les substrats encadrés dans le boîtier.

Ainsi, le positionnement dans le boîtier des substrats encadrés n'est pas définitif. Ils peuvent aisément être retirés du boîtier afin par exemple d'être remplacés ou modifiés.

D'autres caractéristiques et avantages de l'invention apparaîtront à la lecture de la description détaillée qui suit, faite à titre d'exemple non limitatif et en référence aux dessins annexés dans lesquels :
les figures 1a et 1b représentent schématiquement un module électronique selon l'invention, la figure 1 a étant un éclaté et la figure 1 b, une vue en coupe,
la figure 2 illustre schématiquement l'interconnexion électrique entre substrats électroniques et entre substrats électroniques et l'interface d'entrée-sortie, selon une vue en coupe,
la figure 3 représente schématiquement une vue détaillée d'un élément conducteur,
la figure 4 représente schématiquement un éclaté d'un élément d'interconnexion.

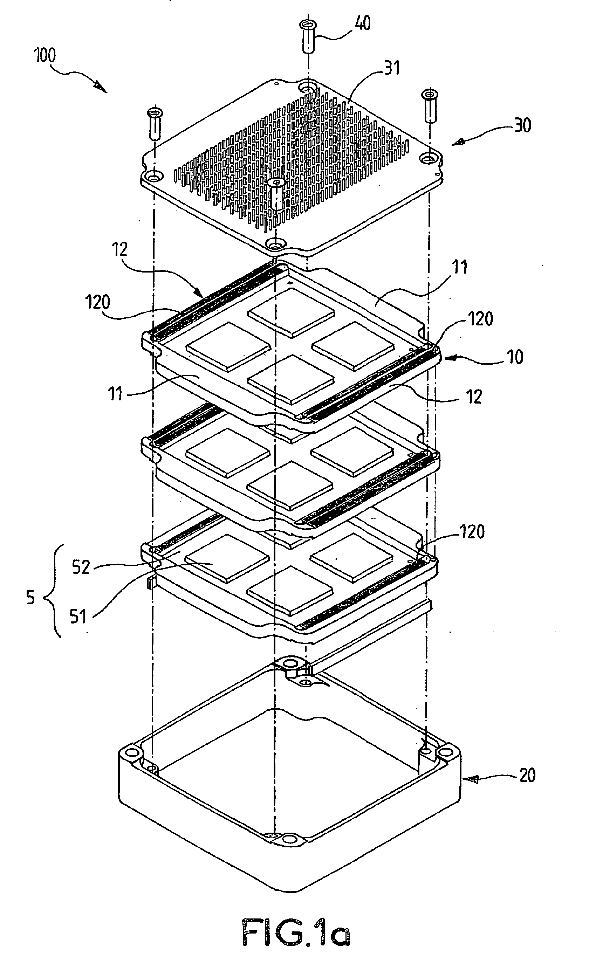

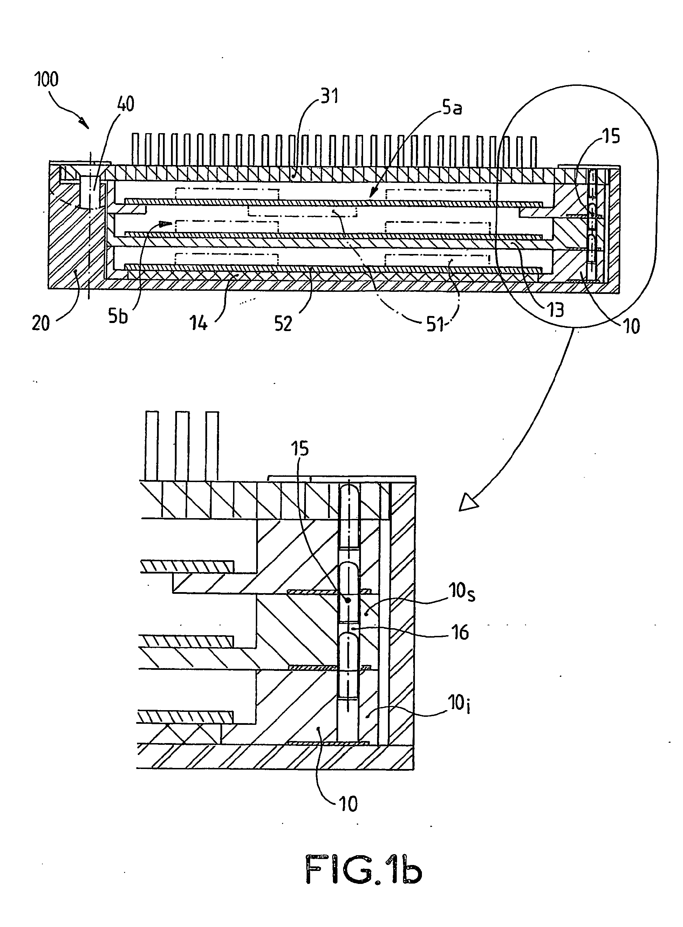

Le module électronique 100 selon l'invention aussi désigné module électronique 3D, comporte comme représenté figures 1a et 1b, plusieurs substrats électroniques 5, par exemple trois substrats 5a, 5b, 5c, chaque substrat 5 étant muni d'un cadre 10 constitué d'un matériau à haute conductivité thermique, les substrats 5 encadrés étant empilés les uns sur les autres dans un boîtier 20 fermé par un capot 30 comportant une interface d'entrée-sortie 31 ; le boîtier 20 est de préférence également constitué d'un matériau à haute conductivité thermique.

Le matériau à haute conductivité thermique est par exemple de l'aluminium, du cuivre ou du graphite. On rappelle que l'aluminium peut dissiper jusqu'à environ 150- W/m x °K (Watt par mètre par degré Kelvin), le cuivre environ 400 W/m x °K.

Chaque cadre 10 a pour fonction d'assurer les échanges thermiques et les contacts électriques entre les substrats 5 et/ou entre un substrat 5 (ou plusieurs) et l'interface d'entrée-sortie 31. Le cadre 10 comporte de préférence quatre côtés. Deux côtés 11 du cadre sont par exemple destinés aux échanges thermiques, alors que les deux autres côtés 12 comportent chacun un élément d'interconnexion 120 destiné aux contacts électriques. Un cadre 10 peut bien sûr ne comporter qu'un élément d'interconnexion 120.

Un substrat électronique 5 comporte de manière classique, un support 52 et des composants 51. Le support 52 peut différer ou être identique d'un substrat à l'autre. On distingue les substrats électroniques notamment en fonction de leur support qui peut être en époxy et l'on parle alors de circuit imprimé, en céramique, en arseniure de gallium (AsGa), ou encore être constitué d'un isolant métallisé, ...

Différents modes de refroidissement illustrés figure 1b peuvent être utilisés pour dissiper la chaleur provenant du substrat 5, c'est-à-dire pour diriger la chaleur du substrat 5 vers son cadre 10.

Le substrat peut être à double face 5a et la chaleur est dirigée par conduction dans le substrat et convection naturelle vers le cadre 10 ; ce mode de refroidissement est bien adapté pour dissiper une puissance comprise entre 0 et environ 2 W.

Le cadre 10 peut également comporter un fond 13 généralement constitué du même matériau que le cadre : le substrat 5b qui n'est alors pas à double face est reporté sur le fond 13 qui agit comme un drain métallique passif ; ce mode de refroidissement est bien adapté pour dissiper une puissance comprise entre environ 2 et 5 W.

Ce fond 13 peut agir comme un drain métallique actif lorsqu'un caloduc 14 est en outre intégré au fond, dans l'épaisseur; ce mode de refroidissement est de préférence choisi pour dissiper une puissance supérieure à environ 5 W, un caloduc pouvant dissiper jusqu'à environ 1000 W/m.°K

Finalement le module électronique 3D peut accepter différentes technologies de substrat (le support pouvant varier d'un substrat à l'autre) et différents modes de refroidissement (le mode de refroidissement pouvant varier d'un cadre à l'autre).

Les substrats 5 encadrés sont empilés dans un boîtier 20 de manière à ce que les côtés 11 des cadres destinés aux échanges thermiques soient en contact les uns avec les autres. Le boîtier 20 qui a bien sûr pour fonction de protéger les substrats 5 de la poussière, des chocs, ... est également apte à dissiper la chaleur : il est de préférence constitué du même matériau que les cadres 10.

Lors de leur empilement dans le boîtier 20, les substrats 5 encadrés sont positionnés entre eux avec précision, notamment pour assurer de bons échanges thermiques d'un cadre à l'autre et une bonne interconnexion électrique entre eux et/ou entre eux et l'interface d'entrée-sortie de la boîte. Ils sont positionnés entre eux de manière réversible : chacun des substrats encadrés empilés dans le boîtier est ainsi amovible.

Pour simplifier les explications concernant le positionnement des cadres, on va considérer deux cadres 10 voisins désignés cadre inférieur 10ᵢ et cadre supérieur 10ₛ, ainsi référencés sur le zoom de la figure 1b. Ce positionnement précis est obtenu au moyen de pions de centrage 15 disposés sur la face supérieure du cadre inférieur 10ᵢ auxquels correspondent des trous ou des renfoncements 16 disposés sur la face inférieure du cadre supérieur 10ₛ et destinés à recevoir les pions de centrage 15 du cadre inférieur 10ᵢ, au fur et à mesure que les substrats 5 encadrés sont empilés dans le boîtier 20. Selon un autre mode de réalisation les pions de centrage sont disposés sur la face inférieure du cadre supérieur et les trous ou renfoncements sur la face supérieure du cadre inférieur. Ces pions de centrage permettent éventuellement de positionner l'un par rapport à l'autre les substrats encadrés avant d'installer l'ensemble des substrats empilés dans le boîtier.

Comme illustré figure 1a, le boîtier 20 peut en outre présenter un profil intérieur spécifique correspondant à un profil extérieur des cadres, complémentaire de celui du boîtier, facilitant ainsi un pré-positionnement des cadres dans le boîtier.

L'ensemble des substrats 5 encadrés est fixé dans le boîtier par des moyens de fixation 40 compris par exemple dans le capot 30 et prévus pour s'adapter au boîtier 20 ; ces moyens de fixation 40 sont par exemple des vis comme illustré figure 1 a et 1 b.

Comme illustré figure 1 b, le capot 30 qui comporte l'interface d'entrée-sortie 31 comprend de préférence également des renfoncements 16 destinés à recevoir les pions de centrage 15 du cadre du 1^{er} substrat 5a de manière à assurer une bonne interconnexion électrique entre l'interface d'entrée-sortie 31 et ce substrat 5a.

Le positionnement des substrats 5 encadrés, les uns par rapport aux autres ou dans le boîtier 20 n'est pas définitif : les substrats 50 encadrés peuvent aisément être retirés du boîtier 20 et être éventuellement désolidarisés les uns des autres, afin par exemple d'être remplacés ou modifiés. Les substrats encadrés sont interchangeables et l'on obtient ainsi un dispositif modulaire.

Le positionnement précis des substrats encadrés les uns par rapport aux autres et de celui de l'ensemble des substrats encadrés dans le boîtier n'a de sens que dans la mesure où chaque substrat 5 est lui-même précisément positionné par rapport à son cadre 10. Les bords d'un cadre présentent un profil en L : les bords du substrat reposent sur la base du L. Lorsque le cadre comporte en outre un fond 13 qui prolonge cette base du L, le substrat 5 repose alors totalement sur le fond 13. Le positionnement précis du substrat 5 dans son cadre 10 peut également être assuré par d'autres pions de centrage présents sur la base du L et correspondant à des trous ou renfoncements présents sur le support du substrat (non représentés). Ainsi positionné par rapport au cadre 10, le substrat 5 est alors fixé au cadre 10 au moyen par exemple d'une colle.

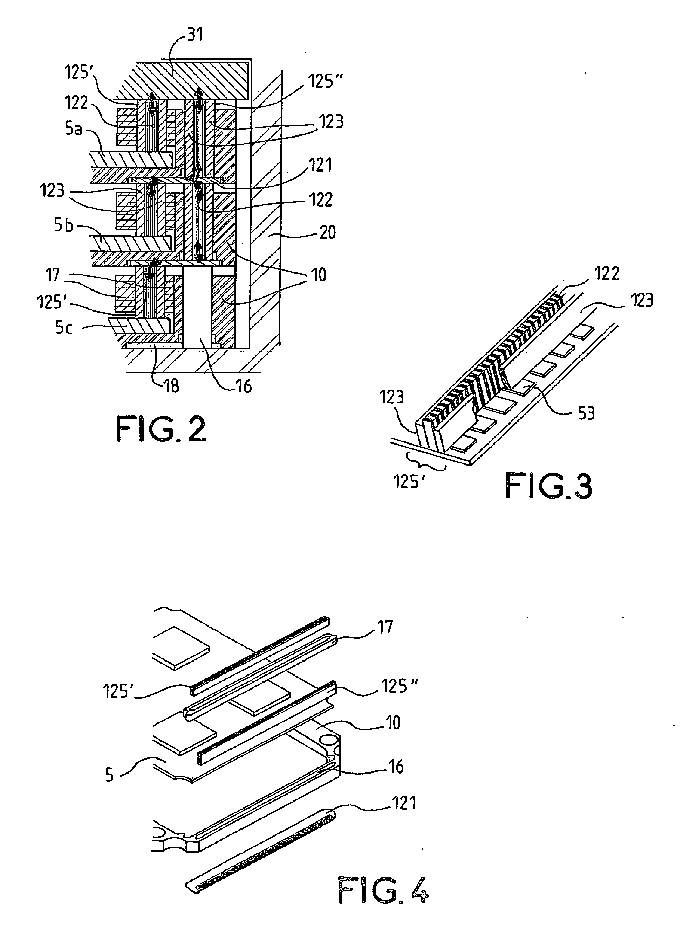

On va à présent considérer plus en détail l'élément d'interconnexion 120 présent dans un côté 12 du cadre en prenant comme exemple un module électronique 3D comportant un 1^{er}, un 2è et un 3è substrats respectivement référencés 5a, 5b et 5c sur la figure 2.

On va tout d'abord considérer l'élément d'interconnexion du dernier cadre, celui du substrat 5c dans notre exemple. Cet élément d'interconnexion comprend un premier connecteur 125' en contact avec les pistes 53 du substrat 5c, comme représenté figure 3.

L'élément d'interconnexion des autres cadres, ceux des substrats 5b et 5a dans notre exemple représenté figure 2, comprend en plus d'un premier connecteur 125' en contact avec les pistes du substrat correspondant, un deuxième connecteur 125" en contact avec un circuit de routage 121. Ce circuit de routage 121 est destiné à être aussi en contact avec le premier connecteur 125' du cadre inférieur et éventuellement avec le deuxième connecteur 125" du cadre inférieur lorsque ce deuxième connecteur 125" existe, comme illustré par les flèches bidirectionnelles. On désigne par bus l'ensemble des éléments 125" communiquant via le (ou les) circuit(s) de routage 121. Le circuit de routage 121 de chacun des éléments d'interconnexion est adapté en fonction des connexions électriques souhaitées. Il est bien sûr très précisément positionné par rapport aux pistes du substrat.

Un circuit de routage est typiquement un circuit imprimé multicouches, (par exemple 5 ou 6 couches) permettant de redistribuer les signaux provenant d'un substrat vers les entrées-sorties du circuit de routage ou inversement. Chaque couche du circuit de routage comprend deux parties l'une en regard de l'élément 125' et donc destinée à être reliée aux pistes du substrat, l'autre en regard de l'élément 125" et donc destinée à être reliée au bus. En fonction des connexions électriques souhaitées entre pistes du substrat et bus, des pistes sont établies d'une partie de la couche vers l'autre. Les pistes ne doivent pas se croiser ; aussi lorsqu'une connexion électrique nécessite qu'une nouvelle piste en croise une autre, cette nouvelle piste est reportée sur une autre couche.

L'interconnexion électrique entre le premier connecteur 125' et le deuxième connecteur 125" du premier substrat 5a est assurée via un circuit de routage (non représenté) inclus dans l'interface d'entrée-sortie 31. L'interconnexion électrique entre le premier connecteur 125' du premier substrat 5a et l'interface d'entrée-sortie 31 est assurée via le circuit de routage de l'interface d'entrée-sortie 31 ou directement.

Comme illustré sur la figure 3, le connecteur 125' ou 125" comporte des anneaux conducteurs 122, compris entre deux isolants 123, en élastomère par exemple. Un autre type de connecteur peut être utilisé. Compte tenu de la largeur des anneaux (par exemple 30 µm) et de leur espacement (par exemple 20 µm), et de ceux des pistes des substrats (environ 200 µm de large, espacées de 150 µm), plusieurs anneaux sont en contact avec une piste.

L'utilisation de circuits de routage permet de modifier les interconnexions entre un substrat et les autres substrats et/ou entre un substrat et l'interface d'entrée-sortie sans intervenir sur le substrat, ni sur le boîtier : il suffit de modifier le circuit de routage. Il en résulte une interchangeabilité et une modularité accrues.

Sur la figure 2 sont en outre représentés, le boîtier 20, une alvéole 16 pré-creusée dans le côté 11 du cadre, et destinée à recevoir le deuxième connecteur 125" lorsqu'il existe, un logement 18 destiné à recevoir un circuit de routage 121 lorsqu'il existe, et une alvéole 17 destinée à recevoir un premier connecteur 125' puis à être ensuite rapportée sur le substrat 5 lui correspondant. Ces éléments sont également représentés sur l'éclaté de la figure 4.

Une fois que les substrats 5a, 5b, 5c encadrés de la figure 2 sont empilés les uns sur les autres dans le boîtier 20 et que l'interface d'entrée-sortie 31 est rapportée sur le substrat 5a encadré supérieur, les connecteurs 125' et 125" et les circuits de routage 121 correspondants sont alors en contact.

Un prototype selon l'invention a été réalisé avec trois substrats. Le module électronique 3D obtenu a environ les dimensions suivantes : 55 mm X 55 mm X 12.6 mm.

Le module électronique selon l'invention peut bien sûr comporter un nombre différent de substrats électroniques.

## Revendications

1. Module électronique (100) comportant une interface d'entrée-sortie (31) et un empilement de plusieurs substrats électroniques (5), chaque substrat électronique comprenant des pistes (53) conductrices et étant apte à être connecté à un autre (ou d'autres) substrat(s) électronique(s) et éventuellement à l'interface d'entrée-sortie (31), **caractérisé en ce que** chaque substrat électronique comprend un cadre (10) constitué d'un matériau à haute conductivité thermique, comprenant plusieurs côtés, dont au moins un premier côté (11) est destiné à être en contact avec le côté correspondant du cadre d'un autre (ou des autres) substrat(s) voisin(s) de manière à assurer la dissipation thermique des substrats électroniques et dont au moins un deuxième côté (12) comprend un élément d'interconnexion (120) destiné à assurer l'interconnexion électrique entre ledit substrat électronique (5) et un autre (ou d'autres) substrat(s) électronique(s) et éventuellement entre ledit substrat électronique (5) et l'interface d'entrée-sortie (31), au moyen d'un circuit de routage (121) compris dans l'élément d'interconnexion (120) ledit circuit de routage (121) étant apte à être adapté et/ou modifié en fonction de l'interconnexion électrique, l'élément d'interconnexion (120) comprenant un premier connecteur (125') en contact avec les pistes conductrices (53) et éventuellement un deuxième connecteur (125") en contact avec un circuit de routage (121) et **en ce que** la connexion entre deux substrats voisins comprenant un substrat inférieur et un substrat supérieur est réalisée au moyen du circuit de routage (121) en contact avec les premier et deuxième connecteurs (125', 125") du substrat supérieur et avec le premier connecteur (125') et, s'il existe, avec le deuxième connecteur (125") du substrat inférieur, l'ensemble des deuxièmes connecteurs (125") communiquant par l'intermédiaire des circuits de routage (121) formant un bus.

2. Module électronique (100) selon la revendication précédente, **caractérisé en ce qu'**au moins un cadre (10) comporte un fond (13) également constitué d'un matériau à haute conductivité thermique.

3. Module électronique (100) selon la revendication précédente, **caractérisé en ce que** le fond (13) comporte un élément (14) à refroidissement à changement de phase.

4. Module électronique (100) selon l'une quelconque des revendications 4 ou 5, **caractérisé en ce qu'**au moins un élément conducteur (125' et/ou 125") comprend des anneaux conducteurs (122) insérés entre deux isolants (123).

5. Module électronique (100) selon l'une quelconque des revendications précédentes, **caractérisé en ce qu'**au moins un circuit de routage (121) est un circuit imprimé multicouches.

6. Module électronique (100) selon l'une quelconque des revendications précédentes, **caractérisé en ce qu'**au moins un cadre (10) comporte des moyens réversibles de positionnement (15, 16) destinés à positionner ledit cadre (10) par rapport au cadre de l'autre substrat électronique voisin et/ou par rapport à l'interface d'entrée-sortie (31).

7. Module électronique (100) selon la revendication précédente, **caractérisé en ce que** les moyens réversibles de positionnement comportent des premiers pions de centrage (15) et des renfoncements (16).

8. Module électronique (100) selon l'une quelconque des revendications précédentes, **caractérisé en ce qu'**au moins un cadre (10) comporte des seconds pions de centrage destinés à positionner ledit substrat (5) dans son cadre (10).

9. Module électronique (100) selon l'une quelconque des revendications précédentes, **caractérisé en ce qu'**au moins un des substrats (5) est fixé à son cadre (10) au moyen d'une colle.

10. Module électronique (100) selon l'une quelconque des revendications précédentes, **caractérisé en ce que** le matériau à haute conductivité est de l'aluminium ou du cuivre ou du graphite.

11. Module électronique (100) selon l'une quelconque des revendications précédentes, **caractérisé en ce qu'**au moins un substrat (5) comporte un support (52) en époxy ou en céramique ou en arsenure de gallium ou en un isolant métallisé.

12. Module électronique (100) selon l'une quelconque des revendications précédentes, **caractérisé en ce qu'**au moins un cadre (10) comporte au moins quatre côtés et **en ce que** deux premiers côtés (11) sont destinés à la dissipation thermique et deux seconds côtés (12) comportent chacun un élément d'interconnexion (120).

13. Module électronique (100)selon l'une quelconque des revendications précédentes, **caractérisé en ce qu'**au moins un substrat présente une surface d'environ 5 X 5 cm².

14. Module électronique (100) selon l'une quelconque des revendications précédentes, **caractérisé en ce qu'**il comporte en outre un boîtier (20) apte à recevoir l'empilement de substrats électroniques (5) encadrés.

15. Module électronique (100) selon l'une quelconque des revendications précédentes, **caractérisé en ce qu'**il comporte un capot (30) comprenant l'interface d'entrée-sortie (31).

16. Module électronique (100) selon la revendication 14 prise en combinaison avec la revendication 15, **caractérisé en ce que** le capot (20) comporte des moyens de fixation (40) au boîtier (20) et **en ce que** les moyens de fixation (40) sont aptes à stabiliser les substrats (5) encadrés dans le boîtier (20).

17. Module électronique (100) selon la revendication précédente, **caractérisé en ce que** les moyens de fixation (40) sont réversibles.

18. Module électronique (100) selon l'une quelconque des revendications 1 à 16, **caractérisé en ce que** le boîtier (20) est constitué d'un matériau à haute conductivité thermique.

19. Module électronique (100) selon l'une quelconque des revendications 1 à 16, **caractérisé en ce que** le boîtier présente un profil intérieur spécifique et **en ce que** chaque cadre présente un profil extérieur complémentaire de celui du boîtier, en vue de faciliter un pré-positionnement des cadres dans le boîtier.

## Claims

1. An electronic module (100) including an input-output interface (31) and a stack of several electronic substrates (5), each electronic substrate comprising conductors (53) and being able to be connected to another (or other) electronic substrate(s) and potentially to the input-output interface (31), **characterized in that** each electronic substrate comprises a frame (10) made up of a material with a high thermal conductivity, comprising several sides, whereof at least a first side (11) is intended to be in contact with the corresponding side of the frame of another (or other) neighboring substrate(s) so as to ensure the thermal dissipation of the electronic substrates and whereof at least a second side (12) comprises an interconnect element (120) intended to ensure the electric interconnection between said electronic substrate (5) and another (or other) electronic substrate(s) and potentially between said electronic substrate (5) and the input-output interface (31), using a routing circuit (121) comprised in the interconnect element (120), said routing circuit (121) being able to be adapted and/or modified as a function of the electric interconnection, the interconnect element (120) comprising a first connector (125') in contact with the conductors (53) and potentially a second connector (125") in contact with a routing circuit (121), and **in that** the connection between two neighboring substrates comprising a lower substrate and an upper substrate is done using the routing circuit (121) in contact with the first and second connectors (125', 125") of the upper substrate and with the first connector (125') and, if it exists, with the second connector (125") of the lower substrate, the set of the two connectors (125") communicating via routing circuits (121) forming a bus.

2. The electronic module (100) according to the preceding claim, **characterized in that** at least one frame (10) includes a bottom (13) also made up of a material with a high thermal conductivity.

3. The electronic module (100) according to the preceding claim, **characterized in that** the bottom (13) includes a phase-change cooling element (14).

4. The electronic module (100) according to any one of claims 4 or 5, **characterized in that** at least one conducting element (125' and/or 125") comprises conducting rings (122) inserted between two insulators (123).

5. The electronic module (100) according to any one of the preceding claims, **characterized in that** at least one routing circuit (121) is a multi-layer printed circuit.

6. The electronic module (100) according to any one of the preceding claims, **characterized in that** at least one frame (10) includes reversible positioning means (15, 16) intended to position said frame (10) relative to the frame of the other neighboring electronic substrate and/or relative to the input/output interface (31).

7. The electronic module (100) according to the preceding claim, **characterized in that** the reversible positioning means comprise first centering pins (15) and reinforcements (16).

8. The electronic module (100) according to any one of the preceding claims, **characterized in that** at least one frame (10) includes second centering pins intended to position said substrate (5) in its frame (10).

9. The electronic module (100) according to any one of the preceding claims, **characterized in that** at least one of the substrates (5) is fixed to its frame (10) using a glue.

10. The electronic module (100) according to any one of the preceding claims, **characterized in that** the high-conductivity material is aluminum or copper or graphite.

11. The electronic module (100) according to any one of the preceding claims, **characterized in that** at least one substrate (5) includes a support (52) made from epoxy or ceramic or gallium arsenide or a metalized insulator.

12. The electronic module (100) according to any one of the preceding claims, **characterized in that** at least one frame (10) includes at least four sides and **in that** two first sides (11) are intended for thermal dissipation and two second sides (12) each include an interconnect element (120).

13. The electronic module (100) according to any one of the preceding claims, **characterized in that** least one substrate has an area of about 5 x 5 cm².

14. The electronic module (100) according to any one of the preceding claims, **characterized in that** it also includes a package (20) able to receive the stack of framed electronic substrate (5).

15. The electronic module (100) according to any one of the preceding claims, **characterized in that** it includes a lid (30) comprising the input-output interface (31).

16. The electronic module (100) according to claim 14 in combination with claim 15, **characterized in that** the lid (20) includes means (40) for fastening to the package (20) and **in that** the fixing means (40) can stabilize the framed substrates (5) in the package (20).

17. The electronic module (100) according to the preceding claim, **characterized in that** the fixing means (40) are reversible.

18. The electronic module (100) according to any one of claims 1 to 16, **characterized in that** the package (20) is made up of a material with a high thermal conductivity.

19. The electronic module (100) according to any one of claims 1 to 16, **characterized in that** the package has a specific inner profile and **in that** each frame has an outer profile complementary to that of the package, in order to facilitate prepositioning of the frames in the package.

## Patentansprüche

1. Elektronisches Modul (100), das eine Ein-/Ausgangsschnittstelle (31) und einen Stapel von mehreren elektronischen Substraten (5) umfasst, wobei jedes elektronische Substrat Leiterbahnen (53) umfasst und so gestaltet ist, dass es mit einem oder mehreren anderen elektronischen Substraten und eventuell mit der Ein-/Ausgangsschittstelle (31) verbunden werden kann, **dadurch gekennzeichnet, dass** jedes elektronische Substrat einen Rahmen (10) umfasst, der aus einem Material mit hoher Wärmeleitfähigkeit gebildet ist, umfassend mehrere Seiten, von denen wenigstens eine erste Seite (11) für einen Kontakt mit der Seite ausgelegt ist, die dem Rahmen eines oder mehrerer Nachbarsubstrate entspricht, auf eine solche Weise, dass eine Wärmeableitung von den elektronischen Substraten gewährleistet wird, und von denen wenigstens eine zweite Seite (12) ein Verbindungselement (120) umfasst, um eine elektrische Verbindung zwischen dem genannten elektronischen Substrat (5) und einem oder mehreren anderen elektronischen Substraten und eventuell zwischen dem elektronischen Substrat (5) und der Ein-/Ausgangsschnittstelle (31) zu gewährleisten, mit Hilfe einer Leitwegschaltung (121), die sich in dem Verbindungselement (120) befindet, wobei die Leitwegschaltung (121) in Abhängigkeit von der elektrischen Verbindung adaptiert und/oder modifiziert werden kann, wobei das Verbindungselement (120) einen ersten Verbinder (125') in Kontakt mit den Leiterbahnen (53) und eventuell einen zweiten Verbinder (125") in Kontakt mit einer Leitwegschaltung (121) umfasst, und dadurch, dass die Verbindung zwischen zwei ein unteres Substrat und ein oberes Substrat umfassenden Nachbarsubstraten mittels der Leitwegschaltung (121) in Kontakt mit dem ersten und dem zweiten Verbinder (125', 125") des oberen Substrats und mit dem ersten Verbinder (125') und ggf. mit dem zweiten Verbinder (125") des unteren Substrats realisiert wird, wobei der Satz aus den beiden Verbindern (125") über die einen Bus bildende Leitwegschaltung (121) kommuniziert.

2. Elektronisches Modul (100) nach dem vorherigen Anspruch, **dadurch gekennzeichnet, dass** wenigstens ein Rahmen (10) einen Boden (13) aufweist, der ebenfalls aus einem Material mit hoher Wärmeleitfähigkeit gebildet ist.

3. Elektronisches Modul (100) nach dem vorherigen Anspruch, **dadurch gekennzeichnet, dass** der Boden (13) ein Element (14) zum Kühlen durch Phasenaustausch umfasst.

4. Elektronisches Modul (100) nach Anspruch 4 oder 5, **dadurch gekennzeichnet, dass** wenigstens ein leitendes Element (125' und/oder 125") Ringleiter (122) umfasst, die zwischen zwei Isolatoren (123) eingeschlossen sind.

5. Elektronisches Modul (100) nach einem der vorherigen Ansprüche, **dadurch gekennzeichnet, dass** wenigstens eine Leitwegschaltung (121) eine mehrschichtige gedruckte Schaltung ist.

6. Elektronisches Modul (100) nach einem der vorherigen Ansprüche, **dadurch gekennzeichnet, dass** wenigstens ein Rahmen (10) umkehrbare Positionierungsmittel (15, 16) zum Positionieren des Rahmens (10) in Bezug auf den Rahmen des anderen elektronischen Nachbarsubstrats und/oder in Bezug auf die Ein-/Ausgangsschnittstelle (31) umfasst.

7. Elektronisches Modul (100) nach dem vorherigen Anspruch, **dadurch gekennzeichnet, dass** die umkehrbaren Positionierungsmittel erste Zentrierstifte (15) und Verstärkungen (16) umfassen.

8. Elektronisches Modul (100) nach einem der vorherigen Ansprüche, **dadurch gekennzeichnet, dass** wenigstens ein Rahmen (10) zweite Zentrierstifte zum Positionieren des Substrats (5) in dem Rahmen (10) umfasst.

9. Elektronisches Modul (100) nach einem der vorherigen Ansprüche, **dadurch gekennzeichnet, dass** wenigstens eines der Substrate (5) mit einem Klebstoff an seinem Rahmen (10) befestigt ist.

10. Elektronisches Modul (100) nach einem der vorherigen Ansprüche, **dadurch gekennzeichnet, dass** das Material mit hoher Leitfähigkeit Aluminium oder Kupfer oder Grafit ist.

11. Elektronisches Modul (100) nach einem der vorherigen Ansprüche, **dadurch gekennzeichnet, dass** wenigstens ein Substrat (5) einen Träger (52) aus Epoxid oder aus Keramik oder aus Galliumarsenid oder einem metallisierten Isolator umfasst.

12. Elektronisches Modul (100) nach einem der vorherigen Ansprüche, **dadurch gekennzeichnet, dass** wenigstens ein Rahmen (10) wenigstens vier Seiten aufweist, und dadurch, dass zwei erste Seiten (11) zur Wärmeableitung bestimmt sind und zwei zweite Seiten (12) jeweils ein Verbindungselement (120) aufweisen.

13. Elektronisches Modul (100) nach einem der vorherigen Ansprüche, **dadurch gekennzeichnet, dass** wenigstens ein Substrat eine Fläche von etwa 5 x 5 cm² hat.

14. Elektronisches Modul (100) nach einem der vorherigen Ansprüche, **dadurch gekennzeichnet, dass** es darüber hinaus ein Gehäuse (20) zum Aufnehmen des Stapels von eingerahmten elektronischen Substraten (5) umfasst.

15. Elektronisches Modul (100) nach einem der vorherigen Ansprüche, **dadurch gekennzeichnet, dass** es einen Deckel (30) umfasst, der die Ein-/Ausgangsschnittstelle (31) umfasst.

16. Elektronisches Modul (100) nach Anspruch 14 in Kombination mit Anspruch 15, **dadurch gekennzeichnet, dass** der Deckel (20) Befestigungsmittel (40) am Gehäuse (20) umfasst, und dadurch, dass die Befestigungsmittel (40) die in dem Gehäuse (20) eingerahmten Substrate (5) stabilisieren können.

17. Elektronisches Modul (100) nach dem vorherigen Anspruch, **dadurch gekennzeichnet, dass** die Befestigungsmittel (40) umkehrbar sind.

18. Elektronisches Modul (100) nach einem der Ansprüche 1 bis 16, **dadurch gekennzeichnet, dass** das Gehäuse (20) aus einem Material mit hoher Wärmeleitfähigkeit gebildet ist.

19. Elektronisches Modul (100) nach einem der Ansprüche 1 bis 16, **dadurch gekennzeichnet, dass** das Gehäuse ein spezifisches Innenprofil hat, und dadurch, dass jeder Rahmen ein Außenprofil komplementär zu dem des Gehäuses hat, um eine Vorpositionierung der Rahmen in dem Gehäuse zu erleichtern.
